# EUROPEAN PATENT SPECIFICATION

(11) **EP 4 292 191 B1**
(45) Date of publication and mention of the grant of the patent: **30.10.2024**
(21) Application number: 22704605.9
(22) Date of filing: 02.02.2022
(51) Int. Cl.: H02J 7/00

(54) **CHARGER**
LADEGERÄT
CHARGEUR

(30) Priority: 09.02.2021 SE 2150139
(43) Date of publication of application: 20.12.2023
(73) Proprietor: Husqvarna AB, 561 82 Huskvarna (SE)
(72) Inventor: TORSTÉNI, Glenn, 433 76 Jonsered (SE); GIDOFF, Anders, 567 33 Vaggeryd (SE)
(86) International application number: PCT/SE2022/050108
(87) International publication number: WO 2022/173344

(56) References cited:
- WO-A1-2021/113426
- US-A1- 2008 290 836
- US-A1- 2015 244 034

## Description

### Technical field

The present disclosure relates to a charger for a battery-operated system, configured to charge a battery pack, the charger comprising a housing, a charging socket in the housing for receiving a battery pack, and charging electronics configured to provide a direct current to electric connectors associated with the charging socket for charging the battery pack, and a fan arrangement for force cooling the battery pack during charging.

### Background

Such chargers are widely used for instance for charging battery packs for battery-operated tools. For example, US 2015/244034 A1 proposes a battery charger with a fan positioned near an opening in a housing of the charger such that the fan may intake air from outside the charger and distribute the air to cool a battery attached to the charger.

One problem with such chargers is how to improve their safety and reliability at a reasonable cost.

### Summary

One object of the present disclosure is therefore to provide a charger with improved safety or reliability. This object is achieved by a charger as defined in claim 1. More particularly, in a charger of the initially mentioned kind, the housing comprises a fan compartment, enclosing the fan, and an electronics compartment, enclosing the charging electronics, wherein the fan compartment and the electronics compartment are separated at least by a wall. Thereby, the fan arrangement is given its own space. Sometimes, moist may appear in the charging socket. For instance, if a battery pack has been used outdoors, perhaps in cool or freezing conditions, and is brough indoors for charging, water from the ambient air may form condensation on the battery that drips into the charging socket. The fan arrangement, in order to be able to force cool the battery pack, needs to connect to the charging socket in some way or the other, but thanks to the wall or the like in between the fan compartment and the electronics department, the charging electronics is shielded from moist in an improved way. This provides better insulation and hence improved safety and reliability.

The fan compartment comprises an air inlet and an air outlet, and typically the fan compartment air outlet is connected to the charging socket.

The air inlet and air outlet may be substantially vertically oriented when the charger is placed on a horizontal surface. This protects the inlet and outlet to some extent from e.g. water droplets coming from above.

The charger comprises a drain in the charging socket which is located lower than the fan compartment air outlet when the charger is placed on a horizontal surface. This prevents any moisture collected in the charging socket from entering the fan compartment. The drain may be located in the vicinity of the electric connectors.

The electronics compartment may be enclosed by a set of walls, and one such wall may be made up of a cooling flange. This enables both a protected, sealed electronics compartment and efficient transfer of heat from that compartment.

Typically, the cooling flange may be made of aluminum and the other walls at least partly of plastic. There may be provided a gasket in between the cooling flange and the other walls.

The cooling flange may be located in a cooling channel which has its inlet and outlet located on the bottom side of the charger. The housing may comprise a fan compartment, enclosing a fan for cooling the battery pack, and the fan compartment and the electronics compartment may be separated at least by a wall.

### Brief description of the drawings

Fig 1 illustrates a charger and a battery pack to be charged.
Figs 2A and 2B show cross sections through the charger of fig 1 with an inserted battery pack.

### Detailed description

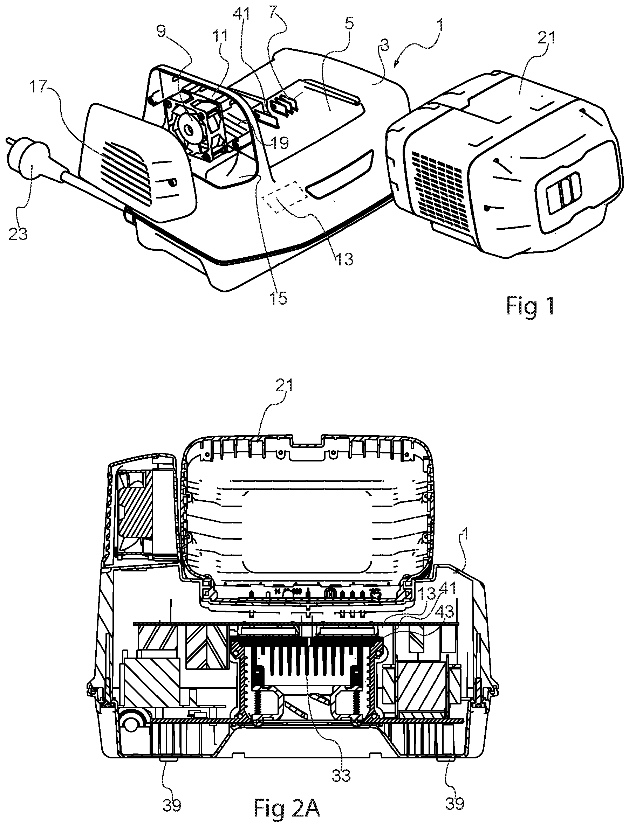

The present disclosure relates generally to a charger 1 in a battery-operated system, which charger is configured to charge a battery pack 21, as illustrated with an example in fig 1.

Such a system may typically employ two or more such battery packs 21 although this is not necessary. Usually, one battery pack is used in a tool (not shown), while the other is being charged. The present disclosure provides a charger 1 with improved reliability and safety.

The charger 1, as shown in fig 1, comprises a housing 3 and a charging socket 5 in the housing for receiving a battery pack 21. Typically, the charger comprises a power plug 23 adapted to be connected to an AC mains socket (not shown) and internal charging electronics, in an electronics compartment 13, typically a rectifier and various control- and communications circuitry, adapted to convert received AC power and provide a DC charging current to electric connectors 7 in the charging socket 5 for charging the battery pack 21.

Charging a battery pack 21 in this way makes the cells in the battery pack develop heat, and the temperature of the battery pack 21 should be kept down in order to provide efficient, fast charging, and to avoid damaging the cells in the battery pack 21, for instance. To this end, a fan arrangement 9 is provided for force cooling the battery pack 21 during charging. The fan arrangement 9 includes a motor and a fan driven by the motor. The battery pack 21 may comprise an air inlet and an air outlet as well as a channel extending therebetween in order to provide efficient cooling of cells therein, but it would also be conceivable to provide cooling by means of external cooling flange, with the cooling effect augmented by forced cooling, for instance.

The present disclosure provides improved safety and reliability of such a charger. The charger 1 is normally but not exclusively intended to be used indoors in dry conditions, but this does not always mean that the charger can be kept dry. For instance, if a battery pack 21 has been used outdoors in cold or even freezing conditions, it may be very cold. Using the battery also means that it develops some heat and can be kept warm to some extent. However, a considerable time may have passed since the last use, and the battery pack 21 may be at a temperature even below 0°C when brought indoors for charging. This means that condensation may be formed on the battery before heating up from charging and that condensation may drip into the charging socket 5 of the charger 1. This implies a risk for malfunction of the charging electronics if water would enter in the charging electronics compartment 13.

In the present disclosure, this problem is eliminated or reduced by providing the housing 3 with a fan compartment 11. This fan compartment 11, which encloses the fan 9, is to some extent separate from an electronics compartment 13 enclosing the charging electronics. The fan compartment 11 and the electronics compartment 13 are typically separated at least by a wall 15. Thereby, the charging electronics can be protected from any moisture coming in contact with the fan arrangement 9. The fan arrangement 9 typically needs to be in contact with the charging socket 5 to be able to cool the battery pack 21 during charging. This is not the case for the charging electronics, however. Thus, by separating the fan compartment 11 from the electronics compartment 13, the insulation of the latter and hence the safety and reliability of the charger can be improved in a cost-efficient manner. The fan arrangement 9 itself can have a higher rating with regard to moisture resistance and lead-throughs for driving the fan and connecting to the DC connectors 7 for the battery pack can be arranged in a watertight manner.

Typically, the fan compartment comprises an air inlet 17 and an air outlet 19 to be able to create a flow through the fan compartment, but the fan compartment could also be open in different ways. Preferably however, the fan compartment has an air outlet 19 is connected to the charging socket 5, such that efficient feeding of air towards the battery pack is achieved. The air inlet 17 receives ambient air.

The inlet 17 and outlet 19 may be vertically oriented, at least extending in planes deviating less than 10 degrees from vertical when the charger is placed on a horizontal surface such that a too large area is not presented to matter, such as rain or dust, coming from above. This protects the inlet and outlet to some extent from rain coming from above if located outdoors. They could also face slightly downwards.

A drain 41 is provided in the charging socket 5 to lead away any water therefrom. This drain 41 is located lower than the fan compartment air outlet 19, when the charger is placed on a horizontal surface, to prevent any moisture collected in the charging socket from entering the fan compartment 11. It may be preferred to locate this drain 41 in the vicinity of, or even more preferred in between, electric connectors 7 of the charger. This also keeps the electric connectors drier.

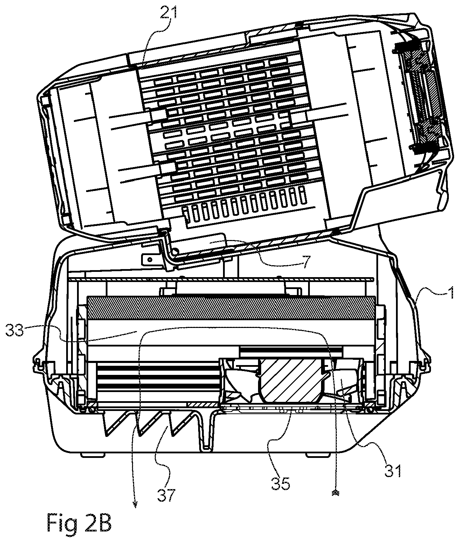

As the fan arrangement used to cool the battery pack is separated from the charging electronics, it may be preferred to arrange a separate cooling arrangement for the charging electronics which is not in direct contact with the charging socket 5. One example of such a cooling arrangement is shown in Fig 2A and 2B illustrating cross sections through the charger of fig 1. This cooling arrangement comprises a fan 31 that feeds ambient air from an inlet 35 in the bottom side of the charger housing 3, via a cooling flange 33, and to an outlet 37 also in the bottom side thereof. The charger may rest on feet 39 that project from the bottom side of the housing to provide an open space under the charger housing 3 by elevating the latter to some extent when resting for instance on a tabletop or the like. It is advantageous to locate the inlet 35 and the outlet 37 in the bottom side of the housing where they are protected, although this is not necessary. One or both may also be located e.g. in the side walls of the housing, for instance.

As mentioned, there is provided a cooling flange 33 in the air flow path, which may be closely connected with the charger electronics. The present disclosure considers providing the electronics compartment 13 as a space defined by a set of walls 33, 41, wherein one such wall is provided by the cooling flange 33. The cooling flange 33 is typically made from extruded aluminum while the remainder of the electronics compartment walls may be provided in one or more pieces by injection moulding plastics, for instance. A sealing device for instance comprising a silicone rubber gasket 43 may optionally be provided in between the cooling flange and the remainder of the electronics compartment walls, in order to provide a more watertight space.

With this configuration, the cooling flange 33 is capable of serving the dual purposes of leading out generated heat from the electronics compartment 13 and to seal off the electronics compartment 13. This arrangement functions very well in combination with the separate fan compartment as described above, but the cooling flange serving this dual purpose could also be used in a charger where the battery pack is passively cooled or has its own internal cooling fan, for instance.

The present disclosure is not restricted to the above-described examples and may be varied and altered in different ways within the scope of the appended claims.

## Claims

1. A charger (1) for a battery-operated system, configured to charge a battery pack, the charger comprising a housing (3) and a charging socket (5) in the housing for receiving a battery pack (21), charging electronics configured to provide a direct current to electric connectors (7) associated with the charging socket for charging the battery pack, and a fan arrangement (9) for force cooling the battery pack during charging, wherein the housing (3) comprises a fan compartment (11), enclosing the fan (9), and an electronics compartment (13), enclosing the charging electronics, wherein the fan compartment (11) and the electronics compartment (13) are separated at least by a wall (15), wherein the fan compartment (11) comprises an air inlet (17) and an air outlet (19), wherein the fan compartment air outlet (19) is connected to the charging socket (5), the charge being **characterized in that** it comprises a drain (41) in the charging socket (5), which is located lower than the fan compartment air outlet (19) when the charger is placed on a horizontal surface.

2. Charger according to claim 1, wherein the air inlet (17) is connected to ambient air.

3. Charger according to any of claims 1-2, wherein the air inlet (17) and air outlet (19) are substantially vertically oriented when the charger is placed on a horizontal surface.

4. Charger according to any of the previous claims, wherein the drain is located in the vicinity of the electric connectors (7).

5. Charger according to any of the previous claims, wherein the electronics compartment is enclosed by a set of walls, (41, 33), and wherein at least one such wall is made up from a cooling flange (33).

6. Charger according to claim 5, wherein the cooling flange (33) is made of aluminum and the other walls (41) are made at least partly of plastic.

7. Charger according to claim 5 or 6, wherein a gasket is provided in between the cooling flange (33) and the other walls (41).

8. Charger according to any of claims 5-7, wherein the cooling flange (33) is located in a cooling channel which has its inlet (35) and outlet (37) located on the bottom side of the charger.

9. Charger according to any of claims 5-8, wherein the housing (3) comprises a fan compartment (11), enclosing a fan (9) for cooling the battery pack, and wherein the fan compartment (11) and the electronics compartment (13) are separated at least by a wall (15).

## Patentansprüche

1. Ladegerät (1) für ein akkubetriebenes System, das konfiguriert ist, um ein Akkupack zu laden, das Ladegerät umfassend ein Gehäuse (3) und eine Ladebuchse (5) in dem Gehäuse zum Aufnehmen eines Akkupacks (21), Ladeelektronik, die konfiguriert ist, um einen Gleichstrom an elektrische Verbinder (7), die mit der Ladebuchse zum Laden des Akkupacks verknüpft sind, bereitzustellen, und eine Lüfteranordnung (9) zum Zwangskühlen Akkupacks während eines Ladens, wobei das Gehäuse (3) ein Lüfterfach (11), das den Lüfter (9) umschließt, und ein Elektronikfach (13), das die Ladeelektronik umschließt, umfasst, wobei das Lüfterfach (11) und das Elektronikfach (13) mindestens durch eine Wand (15) getrennt sind, wobei das Lüfterfach (11) einen Lufteinlass (17) und einen Luftauslass (19) umfasst, wobei der Luftauslass (19) des Lüfterfachs mit der Ladebuchse (5) verbunden ist, wobei die Ladung **dadurch gekennzeichnet ist, dass** sie einen Ablauf (41) in der Ladebuchse (5) umfasst, der tiefer als der Luftauslass (19) des Lüfterfachs liegt, wenn das Ladegerät auf einer horizontalen Oberfläche platziert ist.

2. Ladegerät nach Anspruch 1, wobei der Lufteinlass (17) mit Umgebungsluft verbunden ist.

3. Ladegerät nach einem der Ansprüche 1 bis 2, wobei der Lufteinlass (17) und der Luftauslass (19) im Wesentlichen vertikal ausgerichtet sind, wenn das Ladegerät auf einer horizontalen Oberfläche platziert ist.

4. Ladegerät nach einem der vorhergehenden Ansprüche, wobei der Ablauf in der Nähe der elektrischen Verbinder (7) liegt.

5. Ladegerät nach einem der vorhergehenden Ansprüche, wobei das Elektronikfach durch einen Satz von Wänden (41, 33) umschlossen ist, und wobei mindestens eine solche Wand aus einem Kühlflansch (33) besteht.

6. Ladegerät nach Anspruch 5, wobei der Kühlflansch (33) aus Aluminium besteht und die übrigen Wände (41) mindestens teilweise aus Plastik bestehen.

7. Ladegerät nach Anspruch 5 oder 6, wobei zwischen dem Kühlflansch (33) und den übrigen Wänden (41) eine Dichtung bereitgestellt ist.

8. Ladegerät nach einem der Ansprüche 5 bis 7, wobei der Kühlflansch (33) in einem Kühlkanal liegt, der seinen Einlass (35) und seinen Auslass (37) auf der Unterseite des Ladegeräts hat.

9. Ladegerät nach einem der Ansprüche 5 bis 8, wobei das Gehäuse (3) ein Lüfterfach (11), das einen Lüfter (9) zum Kühlen des Akkupacks umschließt, umfasst, und wobei das Lüfterfach (11) und das Elektronikfach (13) mindestens durch eine Wand (15) getrennt sind.

## Revendications

1. Chargeur (1) pour un système à batterie, configuré pour charger un bloc-batterie, le chargeur comprenant un boîtier (3) et une prise de chargement (5) dans le boîtier pour recevoir un bloc-batterie (21), des composants électroniques de chargement configurés pour fournir un courant continu aux connecteurs électriques (7) associés à la prise de chargement pour charger le bloc-batterie, et un agencement de ventilateur (9) pour forcer le refroidissement du bloc-batterie pendant le chargement, dans lequel le boîtier (3) comprend un compartiment de ventilateur (11) enfermant le ventilateur (9), et un compartiment de composants électroniques (13) enfermant les composants électroniques de chargement, dans lequel le compartiment de ventilateur (11) et le compartiment de composants électroniques (13) sont séparés au moins par une paroi (15), dans lequel le compartiment de ventilateur (11) comprend une entrée d'air (17) et une sortie d'air (19), dans lequel la sortie d'air (19) de compartiment de ventilateur est reliée à la prise de chargement (5), le chargement étant **caractérisé en ce qu'**il comprend un drain (41) dans la prise de chargement (5) qui est situé plus bas que la sortie d'air (19) de compartiment de ventilateur lorsque le chargeur est placé sur une surface horizontale.

2. Chargeur selon la revendication 1, dans lequel l'entrée d'air (17) est reliée à l'air ambiant.

3. Chargeur selon l'une quelconque des revendications 1 à 2, dans lequel l'entrée d'air (17) et la sortie d'air (19) sont sensiblement orientées verticalement lorsque le chargeur est placé sur une surface horizontale.

4. Chargeur selon l'une quelconque des revendications précédentes, dans lequel le drain est situé à proximité des connecteurs électriques (7).

5. Chargeur selon l'une quelconque des revendications précédentes, dans lequel le compartiment de composants électroniques est enfermé par un ensemble de parois (41, 33), et dans lequel au moins l'une desdites parois est constituée d'une bride de refroidissement (33).

6. Chargeur selon la revendication 5, dans lequel la bride de refroidissement (33) est constituée d'aluminium et les autres parois (41) sont au moins partiellement constituées de plastique.

7. Chargeur selon la revendication 5 ou 6, dans lequel un joint est fourni entre la bride de refroidissement (33) et les autres parois (41).

8. Chargeur selon l'une quelconque des revendications 5 à 7, dans lequel la bride de refroidissement (33) est située dans un canal de refroidissement dont l'entrée (35) et la sortie (37) sont situées sur la face inférieure du chargeur.

9. Chargeur selon l'une quelconque des revendications 5 à 8, dans lequel le boîtier (3) comprend un compartiment de ventilateur (11) enfermant un ventilateur (9) pour refroidir le bloc-batterie, et dans lequel le compartiment de ventilateur (11) et le compartiment de composants électroniques (13) sont séparés au moins par une paroi (15).
